# EUROPEAN PATENT SPECIFICATION

(11) **EP 0 592 145 B1**
(45) Date of publication and mention of the grant of the patent: **20.05.1998**
(21) Application number: 93307744.8
(22) Date of filing: 29.09.1993
(51) Int. Cl.: C08L 63/02, C08L 71/12

(54) **Polyphenylene ether/polyepoxide resin system**
Polyphenylenether/Polyepoxid Harzzusammensetzungen
Compositions de résines polyphénylène éther-polyépoxyde

(30) Priority: 09.10.1992 US 958625
(43) Date of publication of application: 13.04.1994
(73) Proprietor: GENERAL ELECTRIC COMPANY, Schenectady, NY 12345 (US)
(72) Inventor: Davis, Michael John, Coshocton, Ohio 43812 (US); Tracy, James Estel, Warsaw, Ohio 43844 (US); Trewiler, Carl Edward, Coshocton, Ohio 43812 (US)
(74) Representative: Szary, Anne Catherine, Dr.

(56) References cited:
- WO-A-92/11307
- DE-A- 1 949 831
- DE-A- 3 207 260
- GB-A- 2 095 680
- US-A- 4 912 172
- CHEMICAL ABSTRACTS, vol. 94, no. 20, 18 May 1981, Columbus, Ohio, US; abstract no. 157838, & JP-A-55 145 725 (TOKYO SHIBAURA ELECTRIC CO., LTD.) 13 November 1980

## Description

### Background of the Invention

The present invention relates to melt processable, curable polymer compositions, to methods of curing them, and to the cured products prepared thereby, said products having excellent dielectric properties. More particularly, it relates to curable compositions comprising polyphenylene ethers and poly-epoxy compounds.

To be suitable for use in the fabrication of laminates for printed circuit boards, resinous compositions must possess unique physical and electrical properties. Inasmuch as circuit board laminates serve both as as insulators and as substrates into which the circuitry is integrated, it is critical that resin system be an excellent dielectric and have insulation resistance. Other electrical properties such as dissipation factor and electrical strength should also meet minimum industry standards. Among the physical properties desired are thermal resistance to withstand the high processing temperatures developed in soldering and de-soldering operations, high copper adhesion forces to allow for extremely small circuit lines, and resistance to solvents such as methylene chloride and the like that are commonly used for degreasing, plating and soldering. Additionally, processing and economic considerations dictate that the resinous compositions have relatively short cure times.

A number of polyphenylene ether-polyepoxide compositions having favorable dielectric properties and utility in circuit board manufacture are known. However, due to deficiencies in one or more properties, many of such compositions have not attained wide commercial use. In specific, while polyphenylene ethers are excellent dielectrics and the properties of combinations thereof with polyepoxides are favorable in this respect, deficiencies are often found in areas such as solvent resistance, flammability, solderability, and resistance to high temperatures. Moreover, times required for curing such compositions typically are too long for effective manufacture of circuit boards in large volume. Consequently, there remains a need for resin systems possessing the unique physical and electrical properties required for circuit board laminates.

DE-A-3207260 discloses curable resin compositions comprising a polyphenylene ether resin, a maleimide compound and/or a cyanate ester compound and an epoxy compound.

### Broad Statement of the Invention

The present invention is directed to a curable composition which utilizes a unique catalyst system facilitating an accelerated cure when used in conjunction with a polyphenylene oxide/epoxy resin blend. This catalyst system comprises an aluminum or zinc diketone salt and an imide resin which has a co-catalytic effect of accelerating the cure. It has been discovered that the incorporation of imide into the catalyst system serves to accelerate the cure, producing rates up to twelve times faster than those experienced with similar formulations lacking the imide.

The compositions of the present invention consist essentially of:
(A) at least one polyphenylene ether having a number average molecular weight of at least 12,000;
(B) an epoxy material selected from the group consisting of (B-1) at least one polyglycidyl ether of a bisphenolic compound, said polyglycidyl ether having an average of at most one aliphatic hydroxy group per molecule, and combinations of said polyglycidyl ether with no more than 30% by weight of (B) of at least one of (B-2) aryl monoglycidyl ethers and (B-3) non-bisphenolic polyepoxy compounds;
wherein the composition comprises up to 90% by weight of component A, based on components A and B;
(C) an effective amount of a curing catalyst comprising an aluminum or zinc salt ; and
(D) an effective amount of an imide curing co-catalyst.

These compositions are hereinafter sometimes designated "curable compositions." The methods of formulating, curing, and using the curable compositions form yet further aspects of the present invention.

Cured compositions prepared in such fashion are homogeneous resins having high physical strength, excellent electrical properties, and capability of fabrication by such operations as coating, injection molding, pultrusion, and resin transfer molding. For many applications, including electrical application such as the preparation of printed circuit boards, the properties of said cured compositions are equivalent or superior to those of cured epoxy resins typically used for the same purposes.

### Detailed Description of the Invention

The polyphenylene ethers (also known as polyphenylene oxides) used as component A in the present invention are a well-known class of polymers. They are widely used in industry, especially as engineering plastics in applications requiring toughness and heat resistance. The polyphenylene ethers comprise a plurality of structural units having the formula : 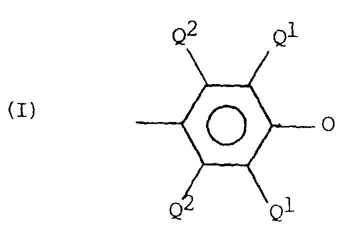 In each of said units independently, each Q¹ independently is halogen, primary or secondary lower alkyl (*i.e*., alkyl containing up to 7 carbon atoms), phenyl, haloalkyl, aminoalkyl, hydrocarbonoxy, or halohydrocarbonoxy wherein at least two carbon atoms separate the halogen and oxygen atoms; and each Q² is independently hydrogen, halogen, primary or secondary lower alkyl, phenyl, haloalkyl, hydrocarbonoxy or halohydrocarbonoxy as defined for Q¹. Examples of suitable primary lower alkyl groups are methyl, ethyl, n-propyl, n-butyl, isobutyl, n-amyl, isoamyl, 2-methylbutyl, n-hexyl, 2,3-dimethylbutyl, 2-,3- or 4-methylpentyl, and the corresponding heptyl groups. Examples of secondary lower alkyl groups are isopropyl, sec-butyl and 3-pentyl. Preferably, any alkyl radicals are straight chain rather than branched. Most often, each Q¹ is alkyl or phenyl, especially C₁₋₄ alkyl, and each Q² is hydrogen.

Both homopolymer and copolymer polyphenylene ethers are included. Suitable homopolymers are those containing, for example, 2,6-dimethyl-1,4-phenylene ether units. Suitable copolymers include random copolymers containing such units in combination with, for example, 2,3,6-trimethyl-1,4-phenylene ether units. Many suitable random copolymers, as well as homopolymers, are disclosed in the patent literature.

Also included are polyphenylene ethers containing moieties which modify properties such as molecular weight, melt viscosity and/or impact strength. Such polymers are described in the patent literature and may be prepared by grafting onto the polyphenylene ether in known manner such non-hydroxy-containing vinyl monomers as acrylonitrile and vinylaromatic compounds (*e.g.*, styrene), or such non-hydroxy-containing polymers as polystyrenes and elastomers. The product typically contains both grafted and ungrafted moieties. Other suitable polymers are coupled polyphenylene ethers in which the coupling agent is reacted in known manner with the hydroxy groups of two polyphenylene ether chains to produce a higher molecular weight polymer containing the reaction product of the hydroxy groups and the coupling agent. Illustrative coupling agents include low molecular weight polycarbonates, quinones, heterocycles, and formals.

Ordinarily the polyphenylene ether will have a number average molecular weight within the range of about 12,000-40,000, preferably about 15,000-40,000, and a weight average molecular weight within the range of about 25,000-80,000, as determined by gel permeation chromatography. Its intrinsic viscosity is most often in the range of about 0.35-0.6 dl/g, as measured in chloroform at 25°C.

The polyphenylene ethers typically are prepared by the oxidative coupling of at least one corresponding monohydroxyaromatic compound. Particularly useful and readily available monohydroxyaromatic compounds include 2,6-xylenol (wherein each Q¹ is methyl and each Q² is hydrogen), whereupon the polymer may be characterized as a poly (2,6-dimethyl-1,4-phenylene ether), and 2,3,6-trimethylphenol (wherein each Q¹ and one Q² is methyl and the other Q² is hydrogen).

A variety of catalyst systems are known for the preparation of polyphenylene ethers by oxidative coupling. There is no particular limitation as to catalyst choice and any of the known catalysts can be used. For the most part, they contain at least one heavy metal compound such as a copper, manganese or cobalt compound, usually in combination with various other materials.

A first class of preferred catalyst systems for polyphenylene ether preparation comprises of those containing a copper compound. Such catalysts are disclosed, for example, in U.S. Patents Nos. 3,306,874, 3,306,875, 3,914,266, and 4,028,341. They are usually combinations of cuprous or cupric ions, halide (i.e., chloride, bromide or iodide) ions and at least one amine.

Catalysts systems containing manganese compounds constitute a second preferred class. They are generally alkaline systems in which divalent manganese is combined with such anions as halide, alkoxide or phenoxide. The manganese is most often present as a complex with one or more complexing and/or chelating agents such as dialkylamines, alkanolamines, alkylenediamines, o-hydroxyaromatic aldehydes, o-hydroxyazo compounds, ω-hydroxyoximes (monomeric and polymeric), o-hydroxyaryl oximes and β-diketones. Also useful are known cobalt-containing catalyst systems. Suitable manganese and cobalt-containing catalyst systems for polyphenylene ether preparation are known in the art by reason of disclosure in numerous patents and publications.

Particularly useful polyphenylene ethers for purposes of this invention are those which comprise molecules having at least one of the end groups of the formulas: 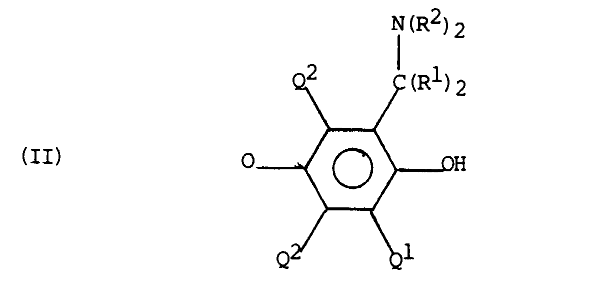 and 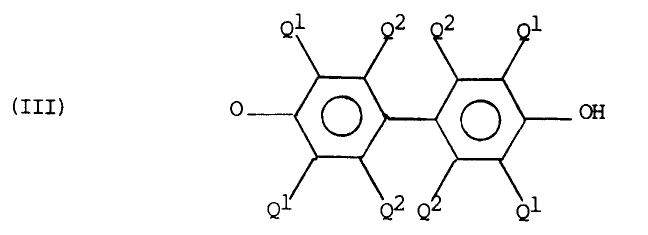 wherein Q¹ and Q² are as previously defined; each R¹ is independently hydrogen or alkyl, with the proviso that the total number of carbon atoms in both R¹ radicals is 6 or less; and each R² is independently hydrogen or a C₁₋₆ primary alkyl radical. Preferably, each R¹ is hydrogen and each R² is alkyl, especially methyl or n-butyl.

Polymers containing the aminoalkyl-substituted end groups of formula II may be obtained by incorporating an appropriate primary or secondary monoamine as one of the constituents of the oxidative coupling reaction mixture, especially when a copper- or manganese-containing catalyst is used. Such amines, especially the dialkylamines and preferably di-n-butylamine and dimethylamine, frequently become chemically bound to the polyphenylene ether, most often by replacing one of the α-hydrogen atoms on one or more Q¹ radicals. The principal site of reaction is the Q¹ radical adjacent to the hydroxy group on the terminal unit of the polymer chain. During further processing and/or blending, the aminoalkyl-substituted end groups may undergo various reactions, probably involving a quinone methide-type intermediate of the formula: 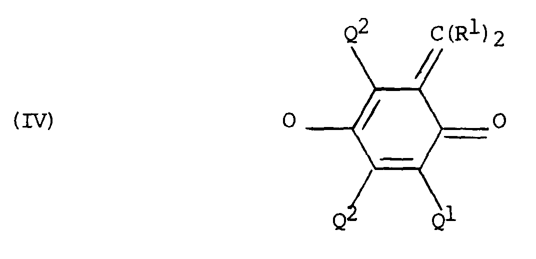 with numerous beneficial effects, often including an increase in impact strength and compatibilization with other blend components. Reference is made to U.S. Patents Nos. 4,054,553, 4,092,294, 4,477,649, 4,477,651, and 4,517,341, the disclosures of which are expressly incorporated by reference herein.

Polymers with 4-hydroxybiphenyl end groups of formula III typically are obtained from reaction mixtures in which a byproduct diphenoquinone of the formula: 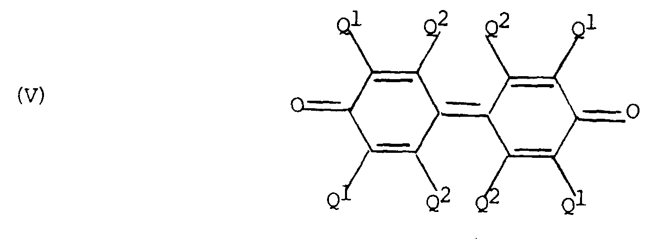 is present, especially in a copper-halide-secondary or tertiary amine system. In this regard, the disclosure of U.S. Patent No.4,477,649 again is pertinent as are those of U.S. Patents Nos. 4,234,706 and 4,482,697, which are also incorporated by reference herein. In mixtures of this type, the diphenoquinone is ultimately incorporated into the polymer in substantial proportions, largely as an end group.

In many polyphenylene ethers obtained under the above-described conditions, a substantial proportion of the polymer molecules, typically constituting as much as about 90% by weight of the polymer, contain end groups having one or frequently both of formulas II and III. It should be understood, however, that other end groups may be present and that the invention in its broadest sense may not be dependent on the molecular structures of the polyphenylene ether end groups.

Component B is an epoxy compound or a mixture of epoxy compounds, of which an essential ingredient is at least one polyglycidyl ether of a bisphenolic compound. The diglycidyl ethers are preferred. They may be prepared conventionally by the reaction of epichlorohydrin with bisphenols, the latter typically having the formula:

(VI) HO-A¹-Y-A²-OH

wherein each of A¹ and A² is a monocyclic divalent aromatic radical and Y is a bridging radical in which one or two atoms separate A¹ from A². The free valence bonds in formula VI are usually in the meta or para positions of A¹ and A² in relation to Y.

In formula VI, the A¹ and A² substituents may be unsubstituted phenylene or substituted derivatives thereof, illustrative substituents (one or more) being alkyl, halo (especially chloro and/or bromo), nitro, alkoxy, and the like. Unsubstituted phenylene radicals are preferred. Both A¹ and A² are preferably p-phenylene, although either may be o- or m-phenylene and the other p-phenylene.

The bridging radical, Y, is one in which one or or two atoms, preferably one, separate A¹ from A². It is most often a hydrocarbon radical and particularly a saturated radical such as methylene, cyclohexylmethylene, ethylene, isopropylidene, neopentylidene, cyclohexylidene or cyclopentadecylidene, especially a gem-alkylene (alkylidene) radical and most preferably isopropylidene. Also included, however, are radicals which contain atoms other than carbon and hydrogen; for example, carbonyl, oxy, thio, sulfoxy and sulfone.

The reaction of epichlorohydrin with bisphenols of formula VI typically produces diglycidyl ethers of the formula: 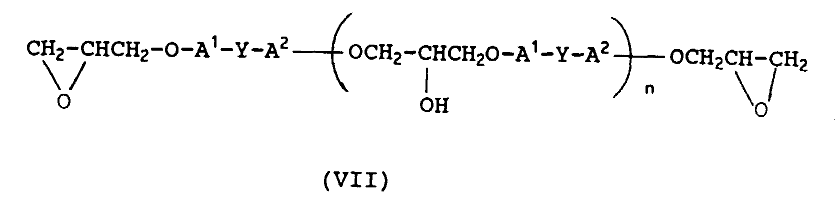 wherein n may have an average value from 0 to about 15. The present invention contemplates the use of ethers containing an average of at most one aliphatic hydroxy group per molecule, *i.e*., the average value of n is up to 1. Commercially available materials of this type, derived from 2,2-bis(4-hydroxyphenyl)propane (bisphenol A), include, for example, EPON 825 (n = 0), EPON 828 (n = about 0.14), and EPON 829, all available from Shell Chemical Company.

Also useful as component B-1 are bisphenolic epoxy novolaks. These are compounds of the type which may be prepared by reaction of a bisphenol of formula VI with formaldehyde followed by formation of the polyglycidyl ether thereof.

Component B usually consists essentially of the above-described component B-1. However, it may include minor proportions of other epoxy compounds. These include (B-2) aryl monoglycidyl ethers such as the phenyl, α-naphthyl and β-naphthyl ethers; and substituted derivatives thereof, the substituents being similar to those previously described for the diglycidyl ethers.

Also included are (B-3) non-bisphenolic polyepoxy compounds. Numerous compounds of this type are known in the art, and all are contemplated for use herein. They are illustrated by alicyclic polyepoxy compounds such as 3,4-epoxycyclohexylmethyl 3,4-epoxycyclohexanecarboxylate, vinylcyclohexene dioxide, phenol-formaldehyde novolak polyglycidyl ethers, resorcinol glycidyl ether, tetra(glycidyloxyphenyl)ethane, diglycidyl phthalate, diglycidyl tehydrophthalate, and diglycidyl hexahydrophthalate.

For the most part, component B will contain a total of no more than about 30% by weight of components B-2 and/or B-3, if any. The mixture of components A and B typically contains component A in proportions in the range of 5-90% by weight, with about 30-85% and particularly about 60-80% being preferred.

An essential feature of the curable compositions of the invention is their homogeneity at temperatures in the range from about 150°C. to just below their decomposition temperature. That is, when heated to temperatures above 150°C, and especially in the range of about 200-225°C, said compositions form a single viscous liquid phase which is readily melt processable.

At lower temperatures, the curable compositions may become opaque by reason of separation into two phases. One phase is a solid polyphenylene ether phase, and the other phase is a polyepoxide-plasticized polyphenylene ether phase which, at high polyepoxide concentrations, becomes a solution of polyphenylene ether in polyepoxide. Under conditions of high polyphenylene ether concentration, a combination of the composition with filler or reinforcing medium, and optionally with curing catalyst, may be handled as a prepreg and has a characteristic "leathery" feel. For present purposes, "prepreg" means a curable article comprising a substrate impregnated with an uncured or partially-cured resinous material.

A further feature is the absence of other components which contribute materially to the essential properties of the composition. While solvents, fillers and reinforcing media, and other inert adjuvants may be present as described hereinafter, unspecified reactive materials are absent It is apparent, therefore, that these compositions do not contain epoxy hardeners as that term is ordinarily understood, *i.e.,* compounds such as diamines which react stoichiometrically with epoxy compounds.

The curable compositions are characterized further by their capability of being controllably-cured upon contact with, for example, an aluminum tris(acetylacetonate) catalyst at a temperature in the above-described range. For actual use in curing, both aluminum and zinc salt catalysts are contemplated. These include the aluminum and zinc salts of diketones of the formula: 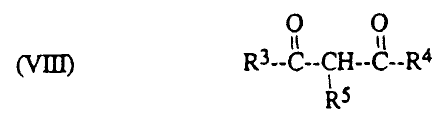 wherein each of R³ and R⁴ independently is a C₁₋₂₀ alkyl or aryl group and R⁵ is hydrogen or a C₁₋₂₀ alkyl or aryl group. Most often, R³ and R⁴ each are methyl groups and R⁵ is hydrogen. The contemplated catalysts include aluminum and zinc salts of stearates, octoates and acetoacetonates. The preferred aluminum salt is the aforementioned aluminum tris(acetylacetonate). The preferred zinc salt is zinc octoate.

Although for certain operations, such as casting, it is possible to employ component C in the absence of a co-catalyst, the crux of the current invention lies in the discovery that incorporation of an imide curing co-catalyst (D) into the curable composition can accelerate the cure rate as much as twelve-fold at press temperatures of less than about 230°C. While various imides may be utilized successfully, provided they have sufficiently low volatility to remain present and active in the composition during the curing operation, the preferred imide is a bismaleimide of formula: 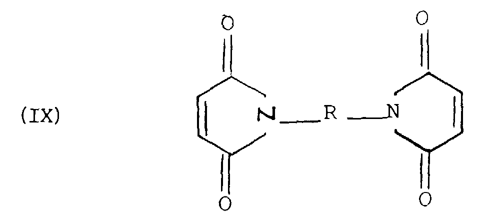 where R is alkyl, aryl, alkyl-aryl, or polymers having a molecular weight up to about 3,000. Representative bismaleimides include, for example, N,N'-(m-phenylene)bismaleimide, N,N'-(4,4'-diphenylmethane)bismaleimide, and aromatic ring subsitiuted variations of the same.

Bismaleimides can be synthesized by various methods such as that disclosed in U.S. Patent No. 2,444,536, which is expressly incorporated herein by reference. Generally, a diluted ether solution of diamine is added to a similar diluted ether solution of maleic anhydride which results in a maleamic acid. The maleamic acid can be disposed in acidic anhydride and converted into the corresponding bis-maleimide in the presence of potassium acetate.

Bismaleimides not only accelerate the cure rate in the manner described, but also allow for pressing at lower temperatures and lend themselves well to continuous lamination production, *i.e.*, full cure at lamination or partial cure followed in sequence by a postcure operation.

Thus, the curable compositions of the present invention consist essentially of components A, B, C, and D. The curing catalyst (component C) typically is present in small quantities, ordinarily about 0.5-10.0% and preferably about 1-5% based on the total weight of components A and B. It is important to note that these catalysts do not become chemically incorporated into the cured composition in a significant way as do the previously mentioned hardeners and similar curing agents added in much larger amounts, typically near stoichiometric. The imide co-catalyst ordinarily is utilized in an amount to provide about 2000-4000 ppm, based on components A, B, C and D, of basic, non-volatilized nitrogen. The amount of component D added, therefore, will be adjusted downward to compensate for the basic nitrogen, if any, present in the polyphenylene ether, which is usually in the range of about 200-1000 ppm, and upward to compensate for volatilization. Balancing these factors, an amount of component D to provide about 1500-4000 ppm of basic nitrogen is usually appropriate.

The curable compositions of this invention are capable of being processed and cured by various methods, and the morphology of the cured products depends to some extent on the method employed. All of said methods, however, involve maintaining the composition at its curing temperature for a time sufficient to effect cure thereof, and this general method of curing, as well as the cured compositions prepared thereby, are still other aspects of the invention. As previously noted, typical curing temperatures are in the range from about 150°C to just below decomposition temperature, and especially about 200-240°C. Curing times seldom exceed 5 minutes when the preferred bismaleimide co-catalyst is utilized.

In one processing method (particularly suitable in connection with such operations such as pultrusion, casting and resin transfer molding and particularly with compositions comprising up to about 50% of component A) the curable composition or a combination thereof with curing catalyst and co-catalyst is melt blended under conventional conditions. A viscous homogeneous mixture is formed which undergoes curing when an effective temperature therefor is attained. If the time required for processing exceeds the curing time, the catalyst or co-catalyst may be added at a later stage.

Either of two different solution processing techniques may be employed, depending on the boiling point of the solvent and the effective curing temperature of the curable composition. In the first method, a relatively high boiling solvent such as toluene is employed and remains in contact with the curable composition as curing is initiated. This method is particularly useful for the preparation of such articles, such as glass cloth-reinforced prepregs, by dipping in or spraying with the solution. Such prepregs are useful, for example, in the preparation of copper-clad printed circuit boards by lamination. When this method is employed, curing takes place in a homogeneous medium.

A second solution method involves the use of a relatively low boiling solvent, such as chloroform, to facilitate blending of the resinous components, catalyst, and co-catalyst. Upon stripping of the solvent, a heterogeneous solid mixture is obtained which, as previously noted, includes solid polyphenylene ether and polyepoxide-plasticized polyphenylene ether. During the heating of this mixture to curing temperatures, the curing reaction competes with further dissolution of polyphenylene ether in the polyepoxide. The result is a two-phase cured system which, particularly when a high proportion of component A is employed, comprises a cured epoxide discontinuous phase surrounded by a polyphenylene ether continuous phase. Such systems are useful, for example, in compression molding.

It should be noted that not all of the curing methods described hereinabove directly utilize the homogeneous property of the curable compositions of the invention. Nevertheless, this property is an important feature of said compositions and contributes in various ways to the desirable properties of the cured compositions prepared therefrom.

Regardless of which processing method is used, the cured compositions of the present invention are typically in the nature of interpenetrating polymer networks having a crosslinked thermoset phase and non-crosslinked thermoplastic phase. When analyzed by dynamic mechanical analysis (DMA), they frequently display one discrete glass transition temperature (T_{g}). Differential scanning calorimetry (DSC) also reveals one T_{g}, generally the same as the value detected by DMA.

The physical and electrical properties of said cured compositions are, in general, comparable or superior to those of cured polyepoxides used commercially for the manufacture of printed circuit boards. Thermal expansion values below and above glass transition temperature are similarly comparable; however, the cured compositions of this invention are superior in this respect in having a T_{g} on the order of 80°C. higher than that of the cured polyepoxide, permitting greater freedom of processing, as well as being non-dusting and having an extremely smooth surface. Cured compositions in which component B is a bisphenol A compound are transparent, since the two phases have identical refractive indices.

When compared to those of other known polyphenylene ether-polyepoxide compositions, the properties of those of the present invention are superior in many respects. These may include physical properties, electrical properties, and conditions of fabrication and curing. By reason of said superior properties in the nature of fabrication conditions, options for laminate production include continuous fabrication with curing times on the order of 5 minutes or less depending on cure temperature and whether or not a postcure is desired.

The precise chemical nature of the above-described cured compositions is not known with certainty, although curing of the epoxy compound probably takes place conventionally, at least in part. It is believed that the polyphenylene ether participates, at least to some extent, in the curing reaction.

The curable compositions of this invention also may contain such conventional materials as flame retardants (*e.g.*, hydrated alumina, decabromodiphenyl ether), fillers and reinforcing media *(e.g.,* glass fiber, polyester fiber, polypropylene fiber, cellulosics, nylon, acrylics), antioxidants, thermal and ultraviolet stabilizers, lubricants, anti-static agents, dyes, pigments and the like, all in conventional proportions. Any fillers present in the potentially curable compositions will, of course, render them nonhomogeneous at the aforementioned temperatures, although they would be homogeneous at said temperatures in the absence thereof.

The following examples show how the present invention has been practiced, but they should not be construed as limiting. All parts and percentages are by weight unless otherwise indicated. The polyphenylene ether used was a poly(2,6-dimethyl-1,4-phenylene ether) having a number average molecular weight of about 20,000 and an intrinsic viscosity in chloroform at 25°C of 0.46 dl/g, and a nitrogen content of about 960 ppm.

### IN THE EXAMPLES

The following is a list of the ingredients used in the Examples, together with the manufacturers thereof:
PPO 640 polyphenylene oxide resin (General Electric Plastics, Selkirk, NY)
EPON 828 epoxy resin (Shell Chemical Co., Houston, TX)
RSM 1206 imide (Shell Chemical Co., Houston, TX)
Al(acac)₃ aluminum tris(acetylacetonate)

### EXAMPLE 1

The following formulation was blended in a 16L reaction vessel equipped with a steam jacket, thermometer, condenser and mechanical stirrer:

**TABLE 1**

| Ingredient | Amount (grams) | Amount (wt.%) |
|---|---|---|
| Toluene | 6600 | 65.08 |
| PPO | 2200 | 21.69 |
| EPON828 | 900 | 8.87 |
| RSM1206 | 332 | 3.27 |
| Al(acac)₃ | 110 | 1.08 |

The vessel was charged with toluene, heated to 60°C and the PPO was added and dissolved with vigorous stirring. The remaining ingredients were then added in the order listed.

Laminates were prepared by first impregnating layers of 2116 glass fiber cloth with the uncured formulation to form prepregs. Layups of 10 prepreg layers were then pressed at 230°C for cure times of 5, 15 and 30 minutes to cure the resin and form 10-ply laminates. The electrical and physical properties of the resulting laminates are presented in Table 5.

### EXAMPLE 2

The following formulation was blended in a 16L reaction vessel equipped with a steam jacket, thermometer, condenser and mechanical stirrer:

**TABLE 2**

| Ingredient | Amount (grams) | Amount (wt.%) |
|---|---|---|
| Toluene | 6600 | 65.43 |
| PPO | 2200 | 21.81 |
| EPON828 | 900 | 8.92 |
| RSM1206 | 332 | 3.29 |
| Al(acac)₃ | 55 | 0.54 |

The vessel was charged with toluene, heated to 60°C and the PPO was added and dissolved with vigorous stirring. The remaining ingredients were then added in the order listed.

Laminates were prepared by first impregnating layers of 2116 glass fiber cloth with the uncured formulation to form prepregs. Layups of 10 prepreg layers were then pressed at 230°C for cure times of 5, 15, 30 and 60 minutes to cure the resin and form 10-ply laminates. The electrical and physical properties of the resulting laminates are presented in Table 5.

### EXAMPLE 3

The following formulation was blended in a 16L reaction vessel equipped with a steam jacket, thermometer, condenser and mechanical stirrer:

**TABLE 3**

| Ingredient | Amount (grams) | Amount (wt.%) |
|---|---|---|
| Toluene | 6600 | 66.16 |
| PPO | 2200 | 22.05 |
| EPON828 | 900 | 9.02 |
| RSM1206 | 166 | 1.66 |
| Al(acac)₃ | 110 | 1.10 |

The vessel was charged with toluene, heated to 60°C and the PPO was added and dissolved with vigorous stirring. The remaining ingredients were then added in the order listed.

Laminates were prepared by first impregnating layers of 2116 glass fiber cloth with the uncured formulation to form prepregs. Layups of 10 prepreg layers were then pressed at 230°C for cure times of 5, 15, 30 and 60 minutes to cure the resin and form 10-ply laminates. The electrical and physical properties of the resulting laminates are presented in Table 5.

### EXAMPLE 4

The following formulation was blended in a 16L reaction vessel equipped with a steam jacket, thermometer, condenser and mechanical stirrer:

**TABLE 4**

| Ingredient | Amount (grams) | Amount (wt.%) |
|---|---|---|
| Toluene | 6000 | 65.93 |
| PPO | 2000 | 21.98 |
| EPON828 | 1000 | 10.99 |
| RSM1206 | 0 | 0.00 |
| Al(acac)₃ | 100 | 1.10 |

The vessel was charged with toluene, heated to 60°C and the PPO was added and dissolved with vigorous stirring. The remaining ingredients were then added in the order listed.

Laminates were prepared by first impregnating layers of 7628 glass fiber cloth with the uncured formulation to form prepregs. Layups of 4 prepreg layers were then pressed at 230°C for cure times of 15 and 30 minutes to cure the resin and form 4-ply laminates. The electrical and physical properties of the resulting laminates are presented in Table 5.

**TABLE 5**

| PPO/Epoxy Formulation Test Results: Physical Properties at Various Cure Times of Imide-Modified vs. Non Imide-Modified Formulations | | | | | | | | |
|---|---|---|---|---|---|---|---|---|
| Ex. | Cure Time (min.) | Solder* Loft | Solder Blister Time (sec)** | | Peel Strength | | H₂0 Absorp. (%) | Etched Thickness (mil) mm |
| | | | (530°F) 277°C | (550°F) 288°C | Dry | Wet*** | | |
| 1 | 5 | no loft | 604 | 484 | 15.6 | 15.2 | 0.14 | (47.2) 1.20 |
| | 15 | no loft | 604 | 40 | 15.2 | 15.4 | 0.15 | (48.9) 1.24 |
| | 30 | no loft | 104 | 36 | 15.0 | -- | 0.13 | (44.3) 1.13 |
| | | | | | | | | |
| 2 | 5 | loft | 10 | 21 | 13.6 | 13.8 | -- | -- |
| | 15 | no loft | 52 | 32 | 13.4 | 12.2 | -- | -- |
| | 30 | no loft | 604 | 23 | 13.0 | 12.2 | -- | -- |
| | 60 | no loft | 604 | 15 | 11.4 | 11.0 | -- | -- |
| | | | | | | | | |
| 3 | 5 | loft | 20 | 16 | 11.0 | 11.6 | -- | -- |
| | 15 | no loft | 17 | 10 | 10.8 | 10.0 | -- | -- |
| | 30 | loft | 21 | 20 | 11.3 | 10.8 | -- | -- |
| | 60 | no loft | 17 | 10 | 10.2 | 10.4 | -- | -- |
| | | | | | | | | |
| 4 | 15 | loft | 12 | 7 | 12.8 | 5.6 | 0.13 | (26.6)0.68 |
| | 30 | loft | 11 | 7 | 10.4 | 21.0 | 0.10 | 29.9 0.76 |

| | | | | | | | | |
|---|---|---|---|---|---|---|---|---|
| * Determined by Z-axis expansion following a 20-60 sec immersion in a solder bath. | | | | | | | | |
| ** Measured as the time required to blister a copper layer coated on the surface of the laminate following the floating of the laminate in a solder bath at the specified temperature. | | | | | | | | |
| *** Measured after immersion for 10 sec in a solder bath at (500°F) 260°C. | | | | | | | | |

The data in Table 5 indicate that the imide-modified, co-catalyzed formulations, *viz.,* Examples 1, 2 and 3, exhibit greater cross-linking and hence improved physical properties for shorter cure times than the formulation that was not co-catalyzed with an imide resin, *viz.,* Example 4.

**TABLE 6**

| Modified PPO/Epoxy Formulation Test Results: Electrical Properties at Various Cure Times Of Imide-Modified vs. Non Imide-Modified Formulations | | | | | | | |
|---|---|---|---|---|---|---|---|
| Ex. | Cure Time (min.) | Diel.Const. | | Dissipation Fact. | | Diel. Breakdown (Kv) | |
| | | Wet | Dry | Wet | Dry | S/S | S/T |
| 1 | 5 | 3.72 | 3.76 | 0.011 | 0.013 | 72 | 71 |
| | 15 | 3.70 | 3.74 | 0.011 | 0.012 | -- | -- |
| | 30 | 3.75 | 3.82 | 0.011 | 0.012 | 44 | 42 |
| | | | | | | | |
| 4 | 15 | 4.20 | 4.26 | 0.011 | 0.013 | 76 | 68 |
| | 30 | 4.11 | 4.22 | 0.013 | 0.015 | 52 | 46 |

The data in Table 6 indicate that the electrical properties of the imide-modified, co-catalyzed formulation, *viz*., Example 1, are comparable to those of the formulation that was not co-catalyzed with an imide resin, *viz.,* Example 4.

## Claims

1. A curable composition consisting essentially of:
(A) at least one polyphenylene ether having a number average molecular weight of at least 12,000;
(B) an epoxy material selected from the group consisting of (B-1) at least one polyglycidyl ether of a bisphenolic compound, said polyglycidyl ether having an average of at most one aliphatic hydroxy group per molecule, and combinations of said polyglycidyl ether with no more than 30% by weight of (B) of at least one of (B-2) aryl monoglycidyl ethers and (B-3) non-bisphenolic polyepoxy compounds;
wherein the composition comprises up to 90% by weight of component A, based on components A and B;
(C) an effective amount of curing catalyst comprising an aluminum or zinc salt; and
(D) an effective amount of an imide curing co-catalyst .

2. The composition of claim 1 wherein component C is a salt of a diketone of the formula: 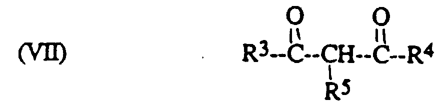 wherein each of R³ and R⁴ independently is a C₁₋₂₀ alkyl or aryl group and R⁵ is hydrogen or a C₁₋₂₀ alkyl or aryl group.

3. The composition according to claim 1 or claim 2 wherein component A is a poly(2,6-dimethyl-1,4-phenylene ether) having a number average molecular weight in the range of 15,000-40,000 and comprises 30-85% by weight, based on components A and B.

4. The composition according to any preceding claim wherein component B consists essentially of component B-1 which has the formula: 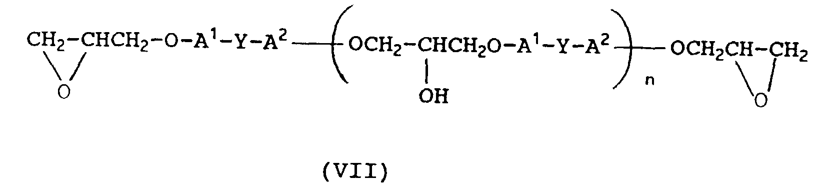 wherein each of A¹ and A² is a monocyclic divalent aromatic radical, Y is a bridging radical in which one or two atoms separate A¹ from A², and n has an average value up to 1.

5. The composition according to any preceding claim wherein component C is aluminum tris(acetylacetonate).

6. The composition according to any preceding claim wherein component C is present in amounts in the range of 0.5-10% weight, based on the total of components A and B.

7. The composition according to any preceding claim wherein component D is a bis-maleimide.

8. The composition according to any preceding claim wherein component D is present in amounts in the range of 0.1-6% by weight, based on the total of components A and B.

9. The composition of any preceding claim wherein component C is a salt of a stearate, a salt of an octoate or a salt of an acetoacetonate.

10. A prepreg composition comprising a composition according to any preceding claim and at least one filler.

11. A method for preparing a cured composition which comprises maintaining the composition of any preceding claim at a temperature in the range from 150°C to just below its decomposition temperature for a time sufficient to effect cure thereof.

## Patentansprüche

1. Eine härtbare Zusamensetzung bestehend im wesentlichen aus:
(A) wenigstens einem Polyphenylenether mit einem Zahlenmittel des Molekulargewichts von wenigstens 12 000;
(B) einem Epoxymaterial ausgewählt aus der Gruppe bestehend aus (B-1) wenigstens einem Polyglycidylether einer bisphenolischen Verbindung, wobei der Polyglycidylether im Mittel wenigstens eine aliphatische Hydroxygruppe pro Molekül hat, und Kombinationen des Polyglycidylethers mit nicht mehr als 30 Gew.-% (B) mit wenigstens einem (B-2) Arylmonoglycidylether und (B-3) nicht bisphenolischen Polyepoxyverbindungen;
wobei die Zusammensetzung bis zu 90 Gew.-% der Komponente A aufweist, bezogen auf die Komponenten A und B;
(C) einer wirksamen Menge eines Härtungskatalysators aufweisend ein Aluminium- oder Zinksalz; und
(D) einer wirksamen Menge eines Imidhärtungscokatalysators.

2. Zusammensetzung nach Anspruch 1, dadurch gekennzeichnet, daß die Komponente C ein Salz eines Diketons der Formel: 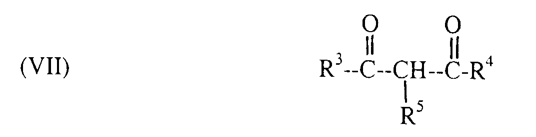 ist, worin R³ und R⁴ jeweils unabhängig eine C₁₋₂₀ Alkyl- oder Arylgruppe sind und R⁵ Wasserstoff oder eine C₁₋₂₀ Alkyl- oder Arylgruppe ist.

3. Zusammensetzung nach Anspruch 1 oder Anspruch 2, dadurch gekennzeichnet, daß Bestandteil A ein Poly(2,6-dimethyl-1,4-phenylenether) ist, der ein Zahlenmittel des Molekulargewichts im Bereich von 15 000- 40 000 hat und die Zusammensetzung 30-85 Gew.-% aufweist, bezogen auf die Komponenten A und B.

4. Zusammensetzung nach einem der vorhergehenden Ansprüche, dadurch gekennzeichnet, daß die Komponente B im wesentlichen besteht aus der Komponente B-1, welche die Formel hat: 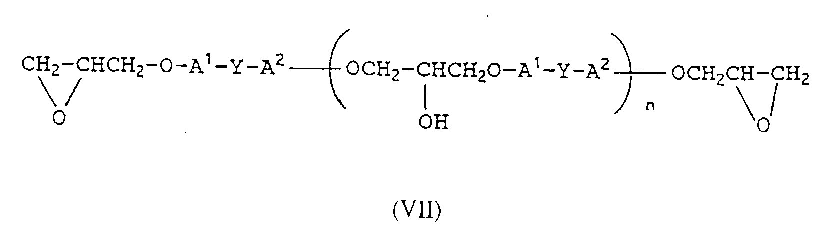 worin jedes der A¹ und A² ein monocyclischer divalenter aromatischer Rest ist, Y ein Brückenrest ist, in dem ein oder zwei Atome A¹ von A² trennen, und n einen Durchschnittswert bis zu 1 hat.

5. Zusammensetzung nach einem der vorhergehenden Ansprüche, dadurch gekennzeichnet, daß die Komponente C Aluminiumtris(acetylacetonat) ist.

6. Zusammensetzung nach einem der vorhergehenden Ansprüche, dadurch gekennzeichnet, daß die Komponente C in einer Menge im Bereich von 0,5-10 Gew.-% zugegen ist, bezogen auf die Gesamtheit der Komponenten A und B.

7. Zusammensetzung nach einem der vorhergehenden Ansprüche, dadurch gekennzeichnet daß die Komponente D ein Bismaleimid ist.

8. Zusammensetzung nach einem der vorhergehenden Ansprüche, dadurch gekennzeichnet, daß die Komponente D in einer Menge im Bereich von 0,1-6 Gew.-% vorhanden ist, bezogen auf die Gesamtheit der Komponenten A und B.

9. Zusammensetzung nach einem der vorhergehenden Ansprüche, dadurch gekennzeichnet, daß die Komponente C ein Salz eines Stearats ist, ein Salz eines Oktoats oder ein Salz eines Acetoacetonats.

10. Eine Prepreg-Zusammensetzung aufweisend eine Zusammensetzung gemäß einem der vorhergehenden Ansprüche und wenigstens einen Füllstoff.

11. Verfahren zur Herstellung einer gehärteten Zusammensetzung, welches aufweist, daß man die Zusammensetzung eines der vorhergehenden Ansprüche bei einer Temperatur im Bereich von 150°C bis gerade unterhalb ihrer Zersetzungstemperatur für eine Zeit hält, die ausreicht, die Härtung zu bewirken.

## Revendications

1. Composition durcissable comprenant principalement :
(A) au moins un poly(phénylène éther) présentant une masse moléculaire moyenne en nombre d'au moins 12 000 ;
(B) un matériau époxy choisi dans l'ensemble constitué par (B-1) au moins un éther polyglycidylique d'un composé bisphénolique, ledit éther polyglycidylique présentant une moyenne d'au plus un groupe hydroxy aliphatique par molécule, et des combinaisons dudit éther polyglycidylique avec au moins l'un de (B2) aryléthers monoglycidyliques et de (B-3) composés polyépoxydes non-bisphénoliques, ces derniers ne représentant pas plus de 30 % en poids de (B) ;
sachant que la composition comprend jusqu'à 90 % en poids de composant (A) par rapport aux composants (A) et (B) ;
(C) une quantité efficace d'un catalyseur de durcissement comprenant un sel d'aluminium ou de zinc ; et
(D) une quantité efficace d'un co-catalyseur de durcissement de type imide.

2. Composition selon la revendication 1, dans laquelle le composant C est un sel d'une dicétone répondant à la formule : 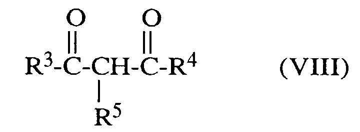 dans laquelle chacun des R³ et R⁴ représente indépendamment un groupe aryle ou alkyle en C₁₋₂₀ et R⁵ représente un atome d'hydrogène ou un groupe aryle ou alkyle en C₁₋₂₀.

3. Composition selon la revendication 1 ou 2, dans laquelle le composant A est un poly(2,6-diméthyl-1,4-phénylène éther) présentant une masse moléculaire moyenne en nombre se situant dans l'intervalle allant de 15 000 à 40 000, et constitue 30 à 85 % en poids des composants A et B.

4. Composition selon l'une quelconque des précédentes revendications, dans laquelle le composant B est constitué principalement par le composant (B-1) qui répond à la formule : 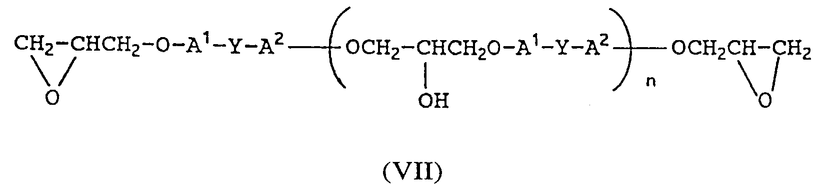 dans laquelle chacun des A¹ et A² représente un groupe aromatique divalent monocyclique, Y représente un groupe pontant dans lequel un ou deux atomes séparent A¹ de A², et n représente une valeur moyenne valant jusqu'à 1.

5. Composition selon l'une quelconque des précédentes revendications, dans laquelle le composant C est le tris(acétylacétonate) d'aluminium.

6. Composition selon l'une quelconque des précédentes revendications, dans laquelle le composant C est présent en des quantités se situant dans l'intervalle allant de 0,5 à 10 % en poids, par rapport au total des composants A et B.

7. Composition selon l'une quelconque des précédentes revendications, dans laquelle le composant D est un bis-maléimide.

8. Composition selon l'une quelconque des précédente revendications, dans laquelle le composant D est présent en des quantités se situant dans l'intervalle allant de 0,1 à 6 % en poids, par rapport au total des composants A et B.

9. Composition selon l'une quelconque des précédentes revendications, dans laquelle le composant C est un sel d'un stéarate, un sel d'un octoate ou un sel d'un acétoacétonate.

10. Composition de préimprégné comprenant une composition selon l'une quelconque des précédentes revendications, et au moins une charge.

11. Procédé pour préparer une composition durcie, qui comprend le maintien de la composition selon l'une quelconque des précédentes revendications à une température se situant dans l'intervalle allant de 150°C jusqu'à une température juste en dessous de sa température de décomposition pendant un temps suffisant pour effectuer son durcissement.
